# EUROPEAN PATENT APPLICATION

(11) **EP 1 496 544 A1**
(43) Date of publication of application: **12.01.2005**
(21) Application number: 03746486.4
(22) Date of filing: 15.04.2003
(51) Int. Cl.: H01L 21/304, B08B 3/02, H01L 21/30, H01L 21/027, G03F 7/42, H05K 3/26

(54) **RESIST FILM REMOVING APPARATUS, METHOD OF REMOVING RESIST FILM, ORGANIC MATTER REMOVING APPARATUS AND METHOD OF REMOVING ORGANIC MATTER**

(30) Priority: 16.04.2002 JP 2002113545
(71) Applicant: Sipec Corporation, Bunkyo-ku, Tokyo 112-0012 (JP)
(72) Inventor: ENDO, Tamio, c/o SIPEC CORPORATION, Tokyo 112-0012 (JP); SATO, Atsushi, c/o SIPEC CORPORATION, Tokyo 112-0012 (JP); AMANO, Yasuhiko, c/o SIPEC CORPORATION, Tokyo 112-0012 (JP); TAMURA, Tetsuji, c/o MITSUI ENG. & SHIP. Co. Ltd., Tamano-shi, Okayama 706-8651 (JP); NISHIMURA, Naoyuki, c/o MITSUI ENG. & SHIP. Co Ltd, Tamano-shi, Okayama 706-8651 (JP); OHMI, Tadahiro, Aoba-ku Sendai-shi, Miyagi 980-0813 (JP); YOKOI, Ikunori, c/o TOHOKU UNIVERSITY, Sendai-shi, Miyagi (JP)
(74) Representative: VOSSIUS & PARTNER
(86) International application number: PCT/JP2003/004750
(87) International publication number: WO 2003/088336

(57) **Abstract**

A sheetfed resist removing apparatus having a substrate (111) being a cleaning object placed therein, includes a treatment chamber (101) forming a closed space, and a spray nozzle (102) to spray a cleaning liquid in a form so-called liquid drops over a surface of the substrate (111), in which the treatment chamber (101) forms the closed space containing the substrate (111) such that the placed substrate (111) faces the spray nozzle (102). This structure allows a cleaning liquid to be in the form of liquid drops in consideration of energy reduction, and permits desirable regulation of the temperature of the liquid drops when the liquid drops contact with the resist film in spraying the cleaning liquid over the resist film on the surface of the substrate (111) to thereby remove the resist film, so that secure removal of the resist film can be accomplished.

## Description

### Technical Field

The present invention relates to an apparatus and a method to perform resist removal which is indispensable in a lithography process for forming a microstructure such as a semiconductor integrated circuit on a semiconductor substrate or a glass substrate, and to an organic matter removing apparatus and a method thereof for a printed board.

### Background Art

At present, there are as resist film removing methods a method to remove a resist film by oxygen plasma ashing, a method to heat and dissolve a resist film using an organic solvent (phenolic, halogenous or other organic solvent at a temperature of 90°C to 130°C), or a heat-and-dissolve method using concentrated sulfuric acid/hydrogen peroxide. All of these methods require time, energy and chemical materials to decompose and dissolve the resist film, which are burdensome to the lithography process. While demands for a new resist removal technique alternative to the ashing or dissolving removal are substantial, developments of removal techniques still count very few. Being developed so far are a technique to utilize the removing feature of the high-frequency supersonic through use of cleaning liquid, a method to spray vapor of cleaning liquid from a nozzle to allow contacting with a resist, and so forth.

However, all of the above removal techniques are difficult to be physically and chemically controlled in a manner suitable for a resist, and in particular, the latter technique of using the vapor of the cleaning liquid poses, while allowing simplification of apparatus structure, a problem in which the temperature upon putting the vapor to the resist cannot be controlled, and a satisfactory removing effect cannot be obtained.

Accordingly, it is an object of the present invention to make the cleaning liquid in a state of liquid drops considering reduction of energy upon the removal, and desirably regulate the temperature of the liquid drops when the liquid drops contact with the resist film (or the organic matter) in spraying cleaning liquid over a resist film (or an organic matter) on a surface of a substrate, so that a secure removal of a resist film (or an organic matter) can be accomplished; and to provide a resist film (or an organic matter) removing apparatus and a resist film (an organic matter) removing method to thereby accomplish a technique symbiosis with environment and not dependent on energy or chemical solvents in removing the resist (an organic matter).

### Summary of the Invention

A resist film removing apparatus according to the present invention is a resist film removing apparatus used in a lithographic process, of which a cleaning object is a flat substrate with a resist film formed on a surface thereof and includes a transferrer to transfer the substrate, an approximately linear-shaped sprayer to spray cleaning liquid in a state of high-temperature liquid drops, and a closer to form a closed space containing the substrate and the sprayer, where, when said sprayer causes the cleaning liquid in the form of liquid drops to contact with the resist film in a state in which the resist film of the substrate faces said sprayer in said closer, a temperature and humidity in the aforesaid closer are regulated as predetermined, and a temperature of the cleaning liquid in the form of liquid drops contacting with the resist film is controlled.

In one mode of a resist film removing apparatus of the present invention, the substrate to be cleaned is a glass substrate of a flat panel display.

An organic matter removing apparatus of the present invention is an organic matter removing apparatus used in a lithography process of a printed board, of which a cleaning object is a flat printed board with an organic matter adhered to a surface thereof, and includes a transferrer to transfer the printed board, an approximately linear-shape sprayer to spray cleaning liquid in a state of high-temperature liquid drops, and a closer to form a closed space containing the printed board and the sprayer, where, when the sprayer causes the cleaning liquid in the form of liquid drops to contact with the organic matter in a state which the organic matter on the substrate faces the sprayer in said closer, a temperature and humidity in the closer are regulated as predetermined, and a temperature of the cleaning liquid in the form of liquid drops contacting with the organic matter is controlled.

A resist film removing apparatus of the present invention is a resist removing apparatus used in a lithography process, an includes a holder to hold a substrate to be cleaned on a surface of which a resist film is formed, a sprayer to spray cleaning liquid in a form of high-temperature liquid drops, and a closer to form a closed space containing the substrate and the sprayer with the sprayer faced to the resist film, in a state in which a temperature and humidity in the closer are regulated as predetermined, and a temperature of the cleaning liquid in the form of liquid drops contacting with the resist film is controlled when the sprayer causes the cleaning liquid in the form of liquid drops to contact with the resist film.

According to an embodiment of a resist film removing apparatus of the present invention, the substrate to be cleaned is a semiconductor substrate.

According to an embodiment of a resist film removing apparatus of the present invention, the substrate to be cleaned is approximately circle-shaped.

According to an embodiment of a resist film removing apparatus of the present invention, the substrate is cleaned while being rotated.

According to an embodiment of a resist film removing apparatus of the present invention, the substrate to be cleaned is a photomask used in photolithography.

According to an embodiment of a resist film removing apparatus of the present invention, the sprayer includes a first nozzle to supply water or liquid chemical and a second nozzle to supply water vapor or high-temperature gas, and the water vapor or high-temperature gas supplied from the second nozzle causes the water or the liquid chemical supplied from the first nozzle to be liquid in a form of liquid drops, and contact with the resist film.

According to an embodiment of a resist film removing apparatus of the present invention, the sprayer includes a first nozzle to supply water or liquid chemical and a second nozzle to supply a high-temperature gas having the humidity of 100% in which water vapor and high-temperature gas are blended, and the high-temperature gas having the humidity of 100% supplied from the second nozzle causes the water or liquid chemical supplied from the first nozzle 1 to be cleaning liquid in a form of liquid drops and contact with the resist film as cleaning liquid.

According to an embodiment of a resist film removing apparatus of the present invention, the sprayer includes a nozzle to supply water or liquid chemical, and the nozzle causes the water or liquid chemical to contact with the resist film as cleaning liquid in a form of liquid drops.

According to an embodiment of a resist film removing apparatus of the present invention, the spryer controls the temperature of the cleaning liquid in the form of liquid drops contacting with the resist film at a value of 70°C or higher.

According to an embodiment of a resist film removing apparatus of the present invention, the liquid chemical contains a resist alteration accelerating component.

According to an embodiment of a resist film removing apparatus of the present invention, water or liquid chemical supplied from the first nozzle is at a temperature of 70°C or higher.

An embodiment of a resist film removing apparatus of the present invention includes a heater to heat water or liquid chemical supplied from the first nozzle at a temperature of 70°C or higher.

A resist film removing method of the present invention is a resist film removing method performed in a lithography process in removing the resist film formed on a surface of a substrate, the resist removing method including the steps of holding the substrate in a closed space, and causing cleaning liquid to contact with the resist film in a form of liquid drops by controlling a temperature thereof by a predetermined temperature regulation, in a state in which a temperature and humidity in the closed space are regulated as predetermined.

According to an embodiment of a resist film removing method, the substrate to be cleaned is a semiconductor substrate.

According to an embodiment of a resist film removing method, the substrate to be cleaned is approximately circle-shaped.

According to an embodiment of a resist film removing method, the substrate is cleaned while being rotated.

According to an embodiment of a resist film removing method, the substrate to be cleaned is a photomask used in photolithography.

A resist film removing method of the present invention is a resist film removing method performed in a lithography process, including the steps of, in removing a resist film formed on a flat surface of a substrate, transferring the substrate into a closed space, and causing cleaning liquid to contact with the resist film in a form of liquid drops by controlling a temperature thereof by a predetermined temperature regulation, in a state in which a temperature and humidity in the closed space are regulated as predetermined.

According to an embodiment of a resist film removing method of the present invention, the substrate to be cleaned is a substrate of a flat panel display.

An organic matter removing method of the present invention is an organic removing method performed in a lithography process of a printed board in removing an organic matter adhered to a flat surface of the printed board, including the steps of transferring the printed board into a closed space, and causing cleaning liquid to contact with the printed board in a form of liquid drops by controlling a temperature thereof by a predetermined temperature regulation, in a state in which a temperature and humidity in the closed space are regulated as predetermined.

According to an embodiment of a resist film removing method of the present invention, water or liquid chemical as cleaning liquid in a form of liquid drops is made in contact with the resist film by water vapor or high-temperature gas.

According to an embodiment of a resist film removing method of the present invention, a temperature of the cleaning liquid in the form of liquid drops contacting with the resist film is controlled within a range at 70°C or higher.

According to an embodiment of a resist film removing method of the present invention, a temperature of the water or liquid chemical is at a value of 70°C or higher.

### Brief Description of the Drawings

Fig. 1 is a sectional view showing a schematic configuration of a resist film removing apparatus according to a first embodiment;
Fig. 2 is a schematic view of a cleaning apparatus provided for an experiment example 1 to confirm an effect of the present invention;
Fig. 3 is a characteristic chart showing a relationship between temperatures of drops at respective positions separate from an outlet of a nozzle and atmospheric temperature in a closed space;
Fig. 4 is a schematic view of a cleaning apparatus provided for an experiment example 2 to confirm an effect of the present invention; and
Fig. 5 is a sectional view showing a schematic structure of a resist film removing apparatus according to a second embodiment.

### Detailed Description of the Preferred Embodiments

The preferred embodiments of the present invention will now be described in detail with reference to the drawings.

These embodiments disclose specific apparatuses and methods to perform resist removal which is indispensable in a lithography process. The lithography process is a process for forming a microstructure such as of a semiconductor integrated circuit, in which a pattern is etched in such a manner that the resist film is adhered on a surface of a substrate, electro magnetic energy is irradiated through interstices in the microstructure pattern formed on a mask, and a pattern is developed by utilizing a solubility difference between the irradiated portion and non-irradiated portion of the resist.

### -First embodiment-

This embodiment provides an example of a sheetfed resist removing apparatus, of which a cleaning object is an approximately rectangular-shape glass substrate provided for a flat panel display (FPD), and a removing method through use thereof.

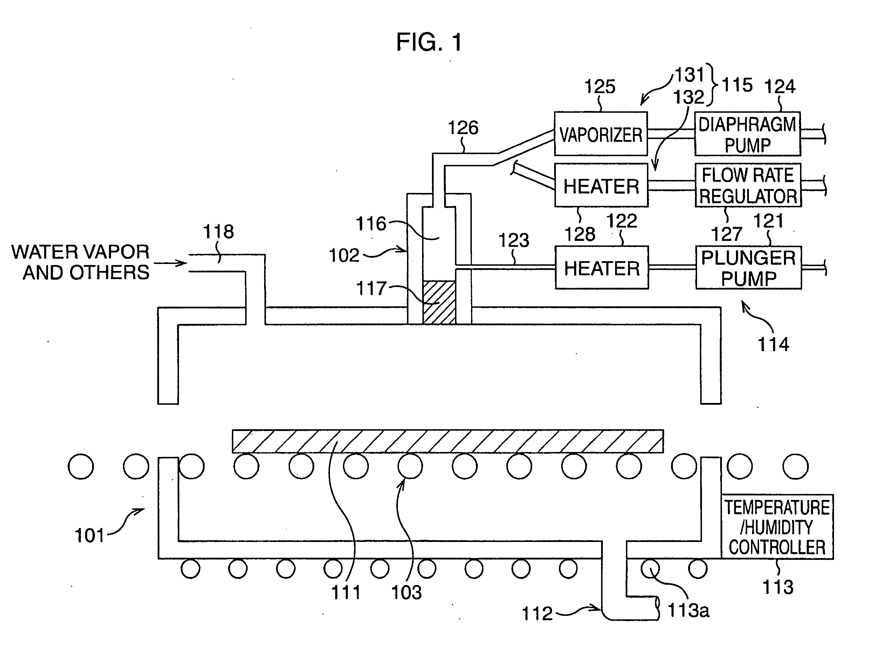

Fig. 1 is a sectional view showing a schematic configuration of the resist film removing apparatus according to the first embodiment.

The apparatus has therein a substrate carrying in/out mechanism 103 in a form of a conveyer on which a glass substrate 111 as a cleaning object is placed to transfer the substrate which is exposing a surface thereof to be cleaned, a treatment chamber 101 having therein the glass substrate 111 and forming a closed space containing the glass substrate 111, in which the glass substrate 111 is carried in and out by the substrate carrying in/out mechanism 103, and a spray nozzle 102 to spray over the surface of the glass substrate 111 the cleaning liquid in a form of the so-called liquid drops.

The treatment chamber 101 is made of a resin or SUS, and has therein a liquid discharging mechanism 112 having a pipe to discharge the cleaning liquid after the processing is completed, a temperature/humidity control mechanism 113 to control the atmosphere in the chamber at a desired temperature and humidity, and a heat quantity supplying pipe 118 to supply a shortfall in heat quantity through water vapor or the like in using the supply line 132 for a high-temperature gas such as N₂ or the like which is described later. The temperature/humidity control mechanism 113 includes, for example, a heating mechanism using a heater or a heating mechanism using a lamp. Here, the diagram illustrates the heating mechanism using heater 113a.

The spray nozzle 102, which is the so-called two-fluid linear-shape nozzle (line nozzle) to supply the cleaning liquid by blending with a desired gas, is provided to face the surface of the glass substrate 111 being placed, and includes a cleaning liquid supply mechanism 114 to supply the cleaning liquid being liquid, a gas supply mechanism 115 to supply gas, a blending chamber 116 to blend the cleaning liquid and gas, and a porous ceramic plate 117 to linearly and uniformly spray the blended cleaning liquid and gas in a form of liquid drops over the surface of the glass substrate 111 which is facing thereto.

Incidentally, a general spray nozzle not having the porous ceramic plate 117 may also be used. The so-called one-fluid linear nozzle may also be used which sprays hot water in a form of liquid drops.

The cleaning liquid supply mechanism 114 has therein a plunger pump 121 to supply a predetermined amount (for example, 20 cc per minute) of a liquid chemical such as, in the case herein, ultrapure water (DIW) or ultrapure water containing a resist alteration accelerating component, a hot water heater 122 to heat the liquid chemical supplied from the plunger pump 121 to a desired temperature, and a pipe 123 to supply the liquid chemical heated by the hot water heater 122 to the blending chamber 116.

As a resist alteration accelerating component, an oxidizer is effective, which is an accelerating component for bridging or oxidizing. For example, hydrogen peroxide alters and eliminates even an ion-implanted resist film in a short time. This is considered to be caused by oxidization through chemical bond of a resist through a strong radical reaction. Ozonized water is also effective as an oxidization accelerating component.

Other oxidizing component, such as Cl₂-H₂O, Br₂-H₂O, I₂-KI, NaClO, NaClO₄, KMnO₄, K₂CrO₇, or Ce(SO₄)₂ can be selected.

Alkali is a strong accelerating component. For example, a caustic alkaline solution with a pH value of about 8 to 14, preferably 10 to 12, is used. This provides the surface of the resist with the wettability and permeability, so that the removal can be performed speedily. As alkali, KOH, NaOH, NACO₃, Ca(OH)₂, Ba (OH)₂, NH₄OH, and TMAH can be used.

The gas supply mechanism 115 allows an optional use of either the water vapor supply line 131 or the high-temperature gas supply line 132 such as of N₂, or a use of both thereof. While generation of water vapor requires a vast vaporization heat, the use of the high-temperature gas such as N₂ saves energy and allows a significant reduction of electric consumption. Further, as described later, the water vapor supply line 131 and the high-temperature gas supply line 132 such as N₂ may be concurrently used to generate and supply a high-temperature gas having a humidity of 100%.

The water vapor supply line 131 has therein a diaphragm pump 124 to supply a predetermined amount (for example, 20 cc per minute) of ultrapure water, a vaporizer 125 to heat the ultrapure water supplied from the diaphragm pump 124 and generate water vapor, and a pipe 126 to supply the water vapor generated by the vaporizer 125 to the blending chamber 116.

On the other hand, the high-temperature gas supply line 132 has therein a gas flow rate regulator 127, and a gas heater 128 to heat the gas to a predetermined temperature.

In order to remove the resist on the surface of the glass substrate 111 using the sheetfed resist removing apparatus, the glass substrate 111 is carried into the treatment chamber 101 by the substrate carrying in/out mechanism 103 first. At that time, the glass substrate 111, being almost enclosed by the treatment chamber 101, faces the porous ceramic plate 117 of the spray nozzle 102.

Subsequently, by controlling, through the temperature/humidity control mechanism 113, the temperature and humidity in the treatment chamber 101 at a predetermined temperature which is in this case 70°C to 90°C, and preferably 80°C to 90°C, and at a humidity of almost 100%, respectively, the cleaning liquid heated approximately to 90°C by the hot water heater 122 and the water vapor generated at around 150°C by the vaporizer 125 or the high-temperature gas generated at around 150°C by the gas heater 128, are blended in the blending chamber 116, and the cleaning liquid in a state of liquid drops is sprayed from the porous ceramic plate 117 over the resist film of the substrate 111 while rotating the substrate 111. At that time, with the transfer of the glass substrate 111, the cleaning liquid is gradually and uniformly sprayed over the entire surface of the substrate.

Further, in removing the resist on the surface of the glass substrate 111 using the sheetfed resist removing apparatus, a mode is also preferable in which the water vapor supply line 131 and the high-temperature gas supply line such as of N₂ forming the gas supply mechanism 115 are concurrently used. In that case, similarly to the above, by controlling the temperature and humidity in the treatment chamber 101 through the temperature/humidity control mechanism 113 at a predetermined temperature which is in this case a range within 70°C to 90°C, and preferably 80°C to 90°C, and at a humidity of almost 100%, respectively, the cleaning liquid heated approximately to 90°C by the hot water heater 122 are blended with a high-temperature gas having a humidity of 100 formed by blending in the blending chamber 116 the water vapor generated at around 150°C by the vaporizer 125 and the high-temperature gas generated at around 150°C by the gas heater 128, and the cleaning liquid in the state of liquid drops is sprayed from the porous ceramic plate 117 over the resist film of the substrate 111 while transferring the glass substrate 111. At that time, the cleaning liquid in a state of liquid drops in the neighborhood of the spray nozzle 102 can be sprayed with the temperature thereof scarcely dropping from the desired temperature (70°C to 90°C, and preferably 80°C to 90°C). And with the transfer of the glass substrate 111, the cleaning liquid is gradually and uniformly sprayed over the entire surface of the substrate.

Here, if the cleaning liquid in a form of liquid drops is sprayed over the surface of the substrate in an open space instead of using the treatment chamber 101 forming a closed space as described in the embodiment, the temperature of liquid drops descends rapidly as it recedes from the outlet of the spray nozzle, affecting the resist removal, but on the other hand, the formation of a closed space using the treatment chamber 101 of the present embodiment permits spraying of the cleaning liquid in the form of liquid drops being controlled at a high temperature, so that the temperature descent of the liquid drops is not caused.

The following description relates to the result of examining the above-described effects brought by the present embodiment through a specific experiment example 1.

### -Experiment example 1-

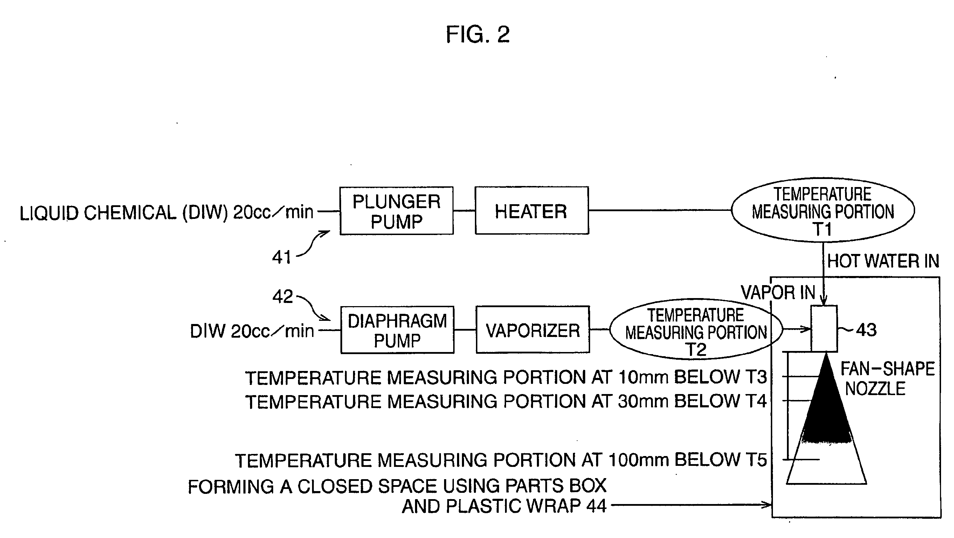

In this example, as shown in Fig. 2, a closed space 44 is formed by using a normal fan-shape two-fluid nozzle 43, connecting to the nozzle 43 a fluid supply mechanism 41 to supply ultrapure water as cleaning liquid and a gas supply mechanism 42 having therein a water vapor supply line, and surrounding the nozzle 43 with a predetermined parts box and a plastic wrap.

Subsequently, while a temperature (hot water temperature) T1 of ultrapure water when being supplied to the nozzle 43 in the cleaning liquid supply mechanism 41, and a temperature (vapor temperature) T2 of water vapor when being supplied to the nozzle 43 in the air supply mechanism 42, are kept almost at predetermined values (T1: around 87°C, T2: around 147°C), a temperature T6 of the atmosphere in the closed space 44 is changed from 19°C to 86°C. At that time, a liquid drop temperature T3 in a position 10 mm below the liquid drop outlet of the nozzle 43, a liquid drop temperature T4 in a position 30 mm below, and a liquid drop temperature T5 in a position 100 mm below, are respectively measured.

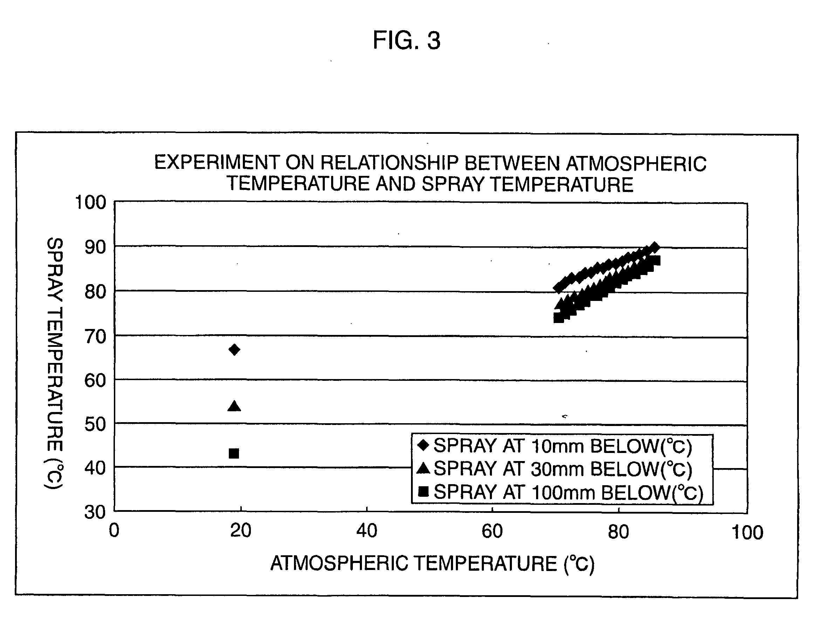

The measurements of the temperatures T1 to T6 are shown in Table 1, based on which, variances of temperatures T3, T4, and T5 when the atmospheric temperature T6 is 20°C and when T6 is 70°C to 90°C are respectively shown in Fig. 3.

Fig. 3 shows that, in a state in which the atmospheric temperature T6 for a case of a conventional cleaning apparatus not having a closed space surrounding the nozzle is set to 20°C, the temperature of the liquid drops rapidly descends as they recede from the liquid drop outlet of the nozzle 43, because the heat is drawn by the surrounding outer air. On the other hand, when a closed space surrounding the nozzle is formed as in the present embodiment, in which the atmospheric temperature T6 is set to 70°C to 90°C, and preferably 80°C to 90°C, the liquid drop temperatures T3, T4, and T5 are significantly close to one another, and the temperature of liquid drops at the liquid drop outlet is almost retained even at a 100 mm distance from the liquid drop outlet.

Since the conventional cleaning apparatus causes the temperature of liquid drops to rapidly descend when leaving the liquid drop outlet of the nozzle, the substrate surface to be cleaned is placed as close as about 10 mm from the liquid drop outlet, but as observed in the above experiment result, even the position as close as about 10 mm therefrom causes a significant drop of the temperature. In contrast, provision of the closed space surrounding the nozzle and maintenance of the atmospheric temperature in the space at a predetermined high level as the present embodiment allow the permissible range of distance between the liquid drop outlet of the nozzle and the substrate surface to expand, and enhance the process margin significantly.

Further, when the cleaning liquid in a state of liquid drops is sprayed over the substrate surface while the gas supply mechanism 115 supplies dry high-temperature gas by using only the supply line 132 for high-temperature gas such as N₂, a substantial power can be saved, but on the other hand, it is known that (1) the cleaning liquid evaporates when contacting with the high-temperature gas in the nozzle due to dryness of the high-temperature gas, and (2) the adiabatic expansion immediately after spraying from the nozzle causes the temperature of the cleaning liquid to drop in the neighborhood of the nozzle. In contrast, in the present embodiment, not only forming a closed space using the treatment chamber 101, but also forming and supplying the cleaning fluid in a form of liquid drops composed of a 100% humidity high-temperature gas and the cleaning liquid by concurrently using the water vapor supply line 131 and the high-temperature gas supply line 132 such as of N₂ permits the temperature of the cleaning liquid to be desirably kept without causing the temperature to drop in the neighborhood of the nozzle, and at a position distant from the nozzle, allows the cleaning liquid to be, through the closed space, sprayed in a form of liquid drops controlled at a high temperature without causing the temperature of the liquid drops to descend.

The following description relates to the result of examining the above-described effects brought by the present embodiment through a specific experiment example 2.

### -Experiment example 2-

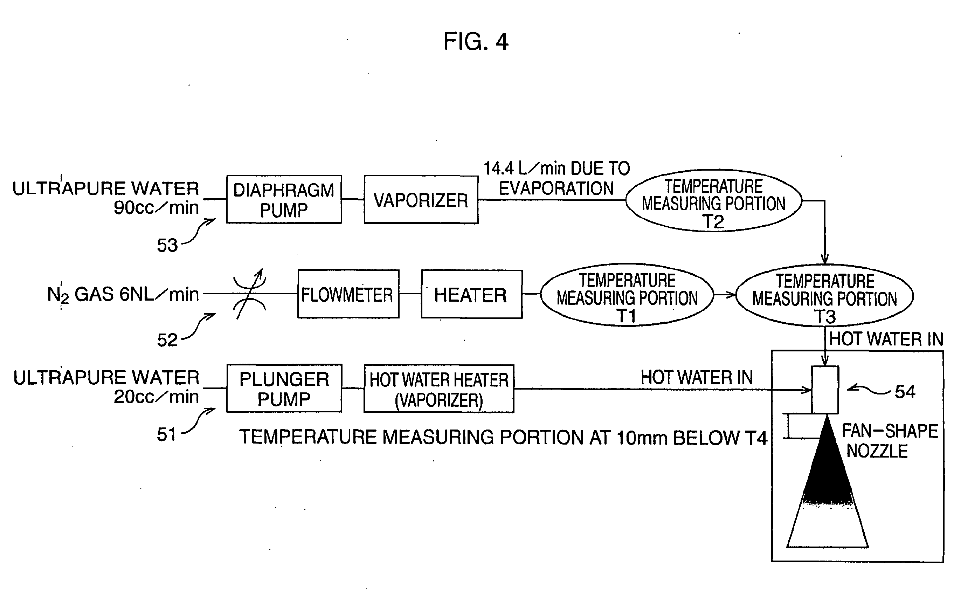

The example, as shown in Fig. 4, uses a normal fan-shaped two-fluid nozzle 54, and connects to the nozzle 54 a cleaning liquid supply mechanism 51 to supply ultrapure water as the cleaning liquid, a dry gas supply mechanism 52 having therein a supply line of high-temperature gas such as N₂, and a water vapor supply mechanism 53 having therein a water vapor supply line, to form a closed space 55 by surrounding the nozzle 54 with a predetermined parts box and a plastic wrap.

Thereafter, the temperature T1 of the high-temperature gas of the dry gas supply mechanism 52 when the dry gas is supplied to the nozzle 54, the temperature T2 of the ultrapure water of the water vapor supply mechanism 53 when the ultrapure water is supplied to the nozzle 54, the temperature T3 of the 100% humidity high-temperature gas in which the high-temperature gas and the vapor of the ultrapure water are blended, and the temperature T4 of the liquid drops in a position 10 mm below a liquid drop outlet of the nozzle 54 are respectively measured.

The measurements of the temperatures T1 to T4 are shown in Table 2.

The temperature of the liquid drops (liquid drop temperature T4) being discharged when the high-temperature gas being added with the water vapor amounting to the relative humidity of 100% is 82°C, so that the target temperature of 80°C or higher is accomplished. Meanwhile, the temperature of the liquid drops when they are sprayed using only high-temperature gas in the same closed space is 42°C, which is not close to the target temperature.

Here, electric power consumption should be minimized since, in addition to high-temperature gas, water vapor is used. Accordingly, the electric power consumed by the experiment is calculated. The result is shown in Table 3.

As shown, power consumption can be reduced by searching an optimal ratio of the water vapor to the high-temperature gas in tune with the target temperature upon spraying liquid drops. The calculation result shows that the power consumption can be reduced by 24% compared to the case in which water vapor solely is used as gas for spraying liquid drops.

As has been explained, with the present embodiment, when the cleaning liquid is sprayed over the resist film on the substrate surface to remove the resist film, the cleaning liquid can be, considering energy reduction, made into liquid drops without evaporating, and further, the temperature of the liquid drops when contacting with the resist film is desirably regulated (at 70°C or higher) so that a secure removal of the resist film comes to be possible, permitting departure from the resources and energy-intensive technique and accomplishment of a technique symbiosis with environment and not dependent on energy or chemical solvents in eliminating the resist.

Note that while the present embodiment cites the glass substrate of FPD as an example of a substrate to be cleaned, the present invention is not limited to such uses, and is also suitable to be used in cleaning the printed board and the like.

### -Second embodiment-

The present embodiment shows as an example of a sheetfed resist removing apparatus and a removing method with the use thereof, of which the cleaning object is an approximately circle-shape semiconductor substrate such as silicon wafer.

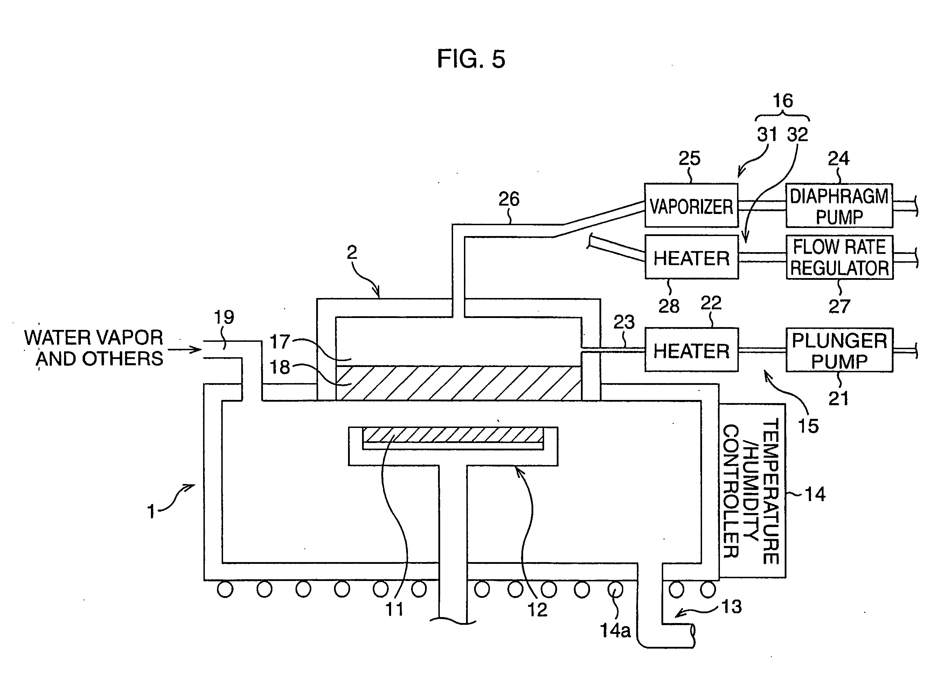

Fig. 5 is a sectional view showing a schematic configuration of a resist film removing apparatus according to the second embodiment.

The apparatus has therein a treatment chamber 1 in which a substrate 11 to be cleaned is placed, forming a closed space containing the substrate 11 in a state in which the substrate 11 is placed therein, and a spray nozzle 2 to spray cleaning liquid in a state of the so-called liquid drops over a surface of the substrate 11.

The treatment chamber 1 is made of resin or SUS, and has therein a spin mechanism 12 to spin the substrate 11 being placed, a substrate carrying in/out mechanism, not shown, to carry the substrate 11 in and out of the chamber, a liquid discharging mechanism 13 having a pipe to discharge the cleaning liquid after the process is completed, a temperature/humidity control mechanism 14 to control an atmosphere in the chamber at desired temperature and humidity; and a heat quantity supplying pipe 19 to supply a shortfall in heat quantity through water vapor and the like upon using the supply line 32 of a high-temperature gas such as N₂ or the like which is described later. The temperature/humidity control mechanism 14 includes, for example, a heating mechanism using a heater or a heating mechanism using a lamp. Herein a heating mechanism using a heater 13a is shown in the diagram. Incidentally, a structure in which cleaning is performed with the substrate 11 being stationary without using the spin mechanism 12 is also possible.

The spray nozzle 2 is the so-called two-fluid nozzle to supply the cleaning liquid blended with a desired gas which is in a state of liquid drops having a particle size of about 10 µm to 200 µm, provided to face the surface of the substrate 11 placed in the spin rotation mechanism 12, having therein a cleaning liquid supply mechanism 15 to supply the cleaning liquid being liquid, a gas supply mechanism 16 to supply the gas, a blending chamber 17 to blend the cleaning liquid and the gas, and a porous ceramic plate 18 having a shape of an approximate circle to spray the blended cleaning liquid and the gas uniformly over the surface of the substrate 11 which is placed to face thereto.

Incidentally, a general spray nozzle not having the porous ceramic plate 18 may also be used. The so-called one-fluid linear-shape nozzle to spray hot water in a form of liquid drops may also be used.

The cleaning liquid supply mechanism 15 has therein a plunger pump 21 to supply a predetermined amount (for example, 20 cc per minute) of liquid chemical, being ultrapure water (DIW), ultrapure water containing a resist alteration accelerating component, or the like in the case herein, a hot water heater 22 to heat the liquid chemical supplied from the plunger pump 21 to a desired temperature, and a pipe 23 to supply the liquid chemical heated by the hot water heater 22 to the blending chamber 17.

As a resist alteration accelerating component, an oxidizer is effective which is an accelerating component for bridging or oxidizing. For example, hydrogen peroxide alters and eliminates even an ion-implanted resist film at in a short time. This is considered to be caused by oxidization through chemical bond of a resist through a strong radical reaction. Ozonized water is also effective as an oxidization accelerating component.

Other oxidizing component, such as Cl₂-H₂O, Br₂-H₂O, I₂-KI, NaClO, NaClO₄, KMnO₄, K₂CrO₇, or Ce (SO₄) ₂ can be selected.

Alkali is a strong accelerating component. For example, a caustic alkaline solution with a pH value of about 8 to 14, preferably 10 to 12, is used. This provides the surface of the resist with the wettability and permeability, leading to a speedy removal operation. As alkali, KOH, NaOH, NACO₃, Ca(OH)₂, Ba(OH)₂, NH₄OH, or TMAH can be used.

The gas supply mechanism 16 allows an optional use either of the water vapor supply line 31 or the high-temperature gas supply line 32 such as of N₂, or a use of both thereof. While generation of water vapor requires a vast vaporization heat, the use of the high-temperature gas such as N₂ saves energy and allows a significant reduction of electric power.

The water vapor supply line 31 has therein a diaphragm pump 24 to supply a predetermined amount (for example, 20 cc per minute) of ultrapure water, a vaporizer 25 to heat the ultrapure water supplied from the diaphragm pump 24 and generate water vapor, and a pipe 26 to supply the water vapor generated by the vaporizer 25 to the blending chamber 17.

On the other hand, the high-temperature gas supply line 32 has therein a gas flow rate regulator 27 and a gas heater 28 to heat the gas to a predetermined temperature.

In order to remove the resist on the surface of the substrate 11 using the sheetfed resist removing apparatus, the substrate 11 is placed in the spin mechanism 12 in the treatment chamber 1 by the substrate carrying in/out mechanism first. At that time, the substrate 11 is in a closed state within the treatment chamber 1, and faces the porous ceramic plate 18 of the spray nozzle 2.

Subsequently, by controlling, through the temperature/humidity control mechanism 14, the temperature and humidity in the treatment chamber 1 at a value within, in this case, 70°C to 90°C, and preferably 80°C to 90°C, and at a humidity of almost 100%, respectively, the cleaning liquid made in a state of liquid drops by blending, in the blending chamber 17, the cleaning liquid heated approximately to 90°C by the hot water heater 22 with the water vapor generated at around 150°C by the vaporizer 25 or the high-temperature gas generated at around 150°C, is sprayed from the porous ceramic plate 18 over the resist film on the substrate 11 uniformly.

In the present embodiment, similarly to the first embodiment, provision of the closed space surrounding the nozzle and maintenance of a predetermined high-temperature of the atmosphere in the space allow the permissible range of distance between the liquid drop outlet of the nozzle and the substrate surface to expand, and enhance the process margin significantly.

As has been explained, with the present embodiment, when the cleaning liquid is sprayed on the resist film over the substrate surface to remove the resist film, the cleaning liquid is made into liquid drops considering energy reduction, and further, the temperature of the liquid drops when contacting with the resist film is desirably regulated (at 70°C or higher) so that a secure removal of the resist film comes to be possible, permitting departure from the resources and energy-intensive technique and accomplishment of a technique symbiosis with environment and not dependent on energy or chemical solvents in eliminating the resist.

Note that while the present embodiment cites the silicon wafer of the semiconductor substrate as an example of a substrate to be cleaned, the present invention is not limited thereto, and is also suitable to be used in cleaning a photomask used in photolithography, for example.

### Industrial Applicability

According to the present invention, in removing a resist film (or an organic matter) by spraying cleaning liquid to the resist film (or the organic matter) on a substrate surface, the cleaning liquid is made into a state of liquid drops considering energy reduction, and further, the temperature of the liquid drops when the liquid drops contact with the resist film (or the organic matter) is desirably regulated, allowing secure removal of the resist film (or the organic matter), whereby a resist film (or an organic matter) removing apparatus and a resist film (organic matter) removing method can be provided which allows departure from the resources and energy-intensive technique, that is to say, accomplishment of a technique symbiosis with environment and not dependent on energy or chemical solvents in eliminating the resist (organic matter).

**Table 1**

| Relationship between atmospheric temperature and temperature of spray from nozzle | | | | | |
|---|---|---|---|---|---|
| Atmospheric temperature (°C) | Spray 10mm below outlet (°C) | Spray 30mm below outlet (°C) | Spray 100mm below outlet (°C) | Vapor temperature (°C) | Hot water temperature (°C) |
| 19 | 67 | 54 | 43 | 146 | 83 |
| 71 | 81 | 77 | 74 | 146 | 86 |
| 72 | 82 | 78 | 75 | 147 | 87 |
| 73 | 83 | 78 | 76 | 148 | 87 |
| 74 | 83 | 79 | 77 | 148 | 88 |
| 75 | 84 | 80 | 78 | 148 | 87 |
| 76 | 84 | 81 | 79 | 148 | 88 |
| 77 | 85 | 81 | 79 | 148 | 88 |
| 78 | 85 | 82 | 80 | 148 | 88 |
| 79 | 86 | 82 | 81 | 148 | 88 |
| 80 | 86 | 83 | 82 | 148 | 88 |
| 81 | 87 | 84 | 83 | 148 | 88 |
| 82 | 88 | 85 | 84 | 148 | 88 |
| 83 | 88 | 85 | 84 | 148 | 88 |
| 84 | 89 | 86 | 85 | 148 | 88 |
| 85 | 89 | 87 | 86 | 148 | 88 |
| 86 | 90 | 88 | 87 | 147 | 88 |

**Table 2**

| | State of fluid before introduction through nozzle | | | | T4 temperature at 10mm below outlet (°C) | Atmospheric temperature (°C) |
|---|---|---|---|---|---|---|
| | Hot water | Gas introducing side | | | | |
| | | T1 N₂ gas | T2 Vapor | T3 After blending | | |
| Air with relative humidity of 100% | 20cc/min 90°C | 6NL/min 205°C | 14.4L/min 157°C | 20.4L/min 133°C | 82 | 80 |
| Dry N₂ gas | 20cc/min 82°C | 18NL/min 213°C | - | - | 42 | 38 |
| Spraying solely using vapor (for reference) | 20cc/min 88°C | | 32L/min 147°C | - | 90 | 86 |
| * Humidity after blending N₂ gas and vapor is not confirmed. | | | | | | |

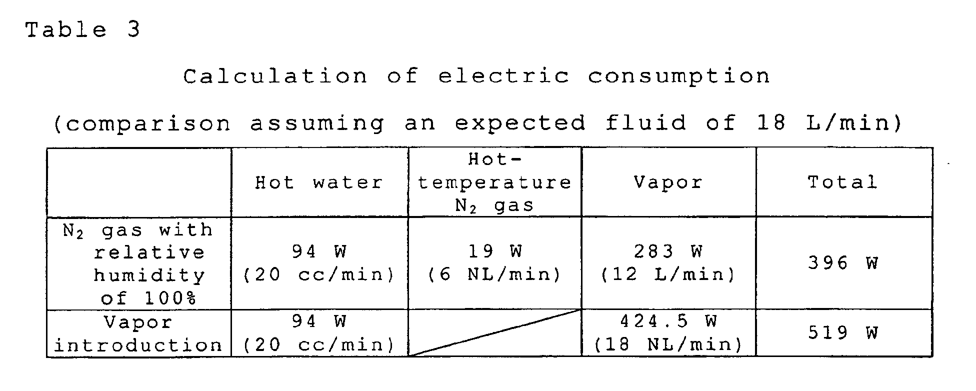

## Claims

1. A resist film removing apparatus used in a lithography process, of which a cleaning object is a flat substrate with a resist film formed on a surface thereof, comprising:
a transferrer to transfer the substrate;
an approximately linear-shape sprayer to spray cleaning liquid in a state of high-temperature liquid drops; and
a closer to form a closed space containing the substrate and said sprayer, and
wherein, when said sprayer causes the cleaning liquid in the form of liquid drops to contact with the resist film in a state in which the resist film of the substrate faces said sprayer in said closer, a temperature and humidity in said closer are regulated as predetermined, and a temperature of the cleaning liquid in the form of liquid drops contacting with the resist film is controlled.

2. The resist removing apparatus according to claim 1, wherein the substrate being the cleaning object is a glass substrate of a flat panel display.

3. The resist film removing apparatus according to claim 1, wherein said sprayer includes a first nozzle to supply water or liquid chemical and a second nozzle to supply water vapor or high-temperature gas, and
the water vapor or high-temperature gas supplied from the second nozzle causes the water or liquid chemical supplied from the first nozzle to be cleaning liquid in the form of liquid drops and contact with the resist film.

4. The resist removing apparatus according to claim 1, wherein said sprayer includes a first nozzle to supply water or liquid chemical, and a second nozzle to supply a high-temperature gas having a humidity of 100% in which water vapor and high-temperature gas are blended, and
the high-temperature gas having the 100% humidity supplied from the second nozzle causes the water or liquid chemical supplied from the first nozzle to be cleaning liquid in the form of liquid drops and contact with the resist film.

5. The resist film removing apparatus according to claim 1, wherein said sprayer includes a nozzle to supply water and liquid chemical, and
the nozzle causes the water or liquid chemical to contact with the resist film as cleaning liquid in the form of liquid drops.

6. The resist film removing apparatus according to claim 1, wherein the temperature of the cleaning liquid in the form of liquid drops contacting with the resist film is controlled at a value of 70°C or higher.

7. The resist film removing apparatus according to claim 1, wherein the liquid chemical contains a resist alteration accelerating component.

8. An organic matter removing apparatus used in a lithography process of a printed board, of which a cleaning object is a flat printed board with an organic matter adhered to a surface thereof, comprising:
a transferrer to transfer the printed board;
an approximately linear-shape sprayer to spray cleaning liquid in a state of high-temperature liquid drops; and
a closer to form a closed space containing the printed board and said sprayer; and
wherein, when said sprayer causes the cleaning liquid in the form of liquid drops to contact with the organic matter, in a state in which the organic matter on the substrate faces said sprayer in said closer, a temperature and humidity in said closer are regulated as predetermined, and a temperature of the cleaning liquid in the form of liquid drops contacting with the organic matter is controlled.

9. A resist removing apparatus used in a lithography process, comprising:
a holder to hold a substrate to be cleaned on a surface of which a resist film is formed;
a sprayer to spray cleaning liquid in a form of high-temperature liquid drops; and
a closer to form a closed space containing the substrate and said sprayer in a state in which said sprayer faces the resist film; and
wherein, when said sprayer causes the cleaning liquid in the form of liquid drops to contact with the resist film, a temperature and humidity in said closer are regulated as predetermined, and a temperature of the cleaning liquid in the form of liquid drops contacting with the resist film is controlled.

10. The resist film removing apparatus according to claim 9, wherein the substrate to be cleaned is a semiconductor substrate.

11. The resist film removing apparatus according to claim 9, wherein the substrate to be cleaned is approximately circle-shaped.

12. The resist film removing apparatus according to claim 11, wherein the substrate is cleaned while being rotated.

13. The resist film removing apparatus according to claim 9, wherein the substrate to be cleaned is a photomask used in a photolithography.

14. The resist film removing apparatus according to claim 1, wherein said sprayer includes a fist nozzle to supply water or liquid chemical, and a second nozzle to supply water vapor or high-temperature gas, and
the water vapor or high-temperature gas supplied from the second nozzle causes the water or liquid chemical supplied from the first nozzle to be cleaning liquid in the form of liquid drops and contact with the resist film.

15. The resist removing apparatus according to claim 9, wherein said sprayer includes a first nozzle to supply water or liquid chemical, and a second nozzle to supply the high-temperature gas having the humidity of 100% in which water vapor and high-temperature gas are blended, and
the high-temperature gas having the humidity of 100% supplied from the second nozzle causes the water or liquid chemical supplied from the first nozzle to be cleaning liquid in the form of liquid drops and contact with the resist film.

16. The resist film removing apparatus according to claim 9, wherein said sprayer includes a nozzle to supply water or liquid chemical, and
the nozzle causes the water or liquid chemical to contact with the resist film as cleaning liquid in the form of liquid drops.

17. The resist film removing apparatus according to claim 9, wherein the temperature of the cleaning liquid in the form of liquid drops.when the liquid drops contact with the resist film is controlled at 70°C or higher.

18. The resist film removing apparatus according to claim 9, wherein the liquid chemical contains a resist alteration accelerating component.

19. The resist film removing apparatus according to claim 14, wherein a temperature of the water or liquid chemical supplied from the first nozzle is 70°C or higher.

20. The resist film removing apparatus according to claim 19, further comprising a heater to heat the water or liquid chemical supplied from the first nozzle at a temperature of 70°C or higher.

21. A resist removing method performed in a lithography process in removing the resist film formed on a surface of a substrate, said resist removing method comprising the steps of: holding the substrate in a closed space; and causing cleaning liquid to contact with the resist film in a form of liquid drops by controlling a temperature thereof by a predetermined temperature regulation, in a state which a temperature and humidity in the closed space are regulated as predetermined.

22. The resist film removing method according to claim 21, wherein the substrate to be cleaned is a semiconductor substrate.

23. The resist film removing method according to claim 22, wherein the substrate to be cleaned is approximately circle-shaped.

24. The resist film removing method according to claim 23, wherein the substrate is cleaned while being rotated.

25. The resist removing method according to claim 22, wherein the substrate to be cleaned is a photomask used in photolithography.

26. The resist film removing method according to claim 21, wherein water vapor or high-temperature gas causes water or liquid chemical to be cleaning liquid in a form of liquid drops and contact with the resist film.

27. The resist film removing method according to claim 26, wherein the water or liquid chemical is at a value of 70°C or higher.

28. The resist film removing method according to claim 21, wherein a temperature of the cleaning liquid in the form of liquid drops contacting with the resist film is controlled in a value range of 70°C or higher.

29. The resist removing method according to claim 21, wherein the liquid chemical contains a resist alteration acceleration component.

30. A resist film removing method performed in a lithography process in removing a resist film formed on a flat surface of a substrate, comprising the steps of: transferring the substrate into a closed space; and causing cleaning liquid to contact with the resist film in a form of liquid drops by controlling a temperature thereof by a predetermined temperature regulation, in a state in which a temperature and humidity in the closed space are regulated as predetermined.

31. The resist film removing method according to claim 30, wherein the substrate to be cleaned is a substrate of a flat panel display.

32. The resist film removing method according to claim 30, wherein a temperature of the cleaning liquid in the form of liquid drops contacting with the resist film is controlled at a value of 70°C or higher.

33. An organic matter removing method performed in a lithography process of a printed board in removing an organic matter adhered to a flat surface of the printed board, comprising the steps of: transferring the printed board into a closed space; and causing cleaning liquid to contact with the printed board in a form of liquid drops by controlling a temperature thereof by a predetermined temperature regulation, in a state in which a temperature and humidity in the closed space are regulated as predetermined.
